# EUROPÄISCHE PATENTSCHRIFT

(11) **EP 2 260 511 B1**
(45) Veröffentlichungstag und Bekanntmachung des Hinweises auf die Patenterteilung: **21.09.2011**
(21) Anmeldenummer: 09727432.8
(22) Anmeldetag: 03.03.2009
(51) Int. Cl.: H01L 23/24

(54) **BAUELEMENTANORDNUNG UND VERFAHREN ZUR HERSTELLUNG EINER BAUELEMENTANORDNUNG**
COMPONENT ARRANGEMENT AND METHOD FOR PRODUCING A COMPONENT ARRANGEMENT
AGENCEMENT DE COMPOSANTS ET PROCÉDÉ DE FABRICATION D UN AGENCEMENT DE COMPOSANTS

(30) Priorität: 03.04.2008 DE 102008017012
(43) Veröffentlichungstag der Anmeldung: 15.12.2010
(73) Patentinhaber: Dr. Johannes Heidenhain GmbH, 83301 Traunreut (DE)
(72) Erfinder: ANGERER, Roman, 83435 Bad Reichenhall (DE)
(86) Internationale Anmeldenummer: PCT/EP2009/052497
(87) Internationale Veröffentlichungsnummer: WO 2009/121675

(56) Entgegenhaltungen:
- DE-A1- 10 153 211
- JP-A- 58 107 657
- JP-A- 61 102 758
- US-A1- 2004 212 082

## Beschreibung

Die vorliegende Erfindung betrifft eine Bauelementanordnung sowie ein Verfahren zur Herstellung einer Bauelementanordnung.

Eine optoelektronische Bauelementanordnung ist z.B. aus der US 7,149,091 B2 bekannt. Auf einem Trägerelement ist hierbei ein Halbleiter-Bauelement angeordnet, das über mehrere Kontaktierungs-Bonddrähte elektrisch mit mindestens einer freiliegenden Kontaktfläche auf dem Trägerelement verbunden ist. Die Kontaktierungs-Bonddrähte sind zusammen mit dem Halbleiter-Bauelement vollständig in einen Verguss eingebettet, der aus einer geeigneten Vergussmasse besteht. Ferner sind Fließstopmittel vorgesehen, die ein unkontrolliertes Verfließen der Vergussmasse um das Halbleiter-Bauelement auf dem Trägerelement verhindern, bevor das Vergussmaterial ausgehärtet ist. Als Fließstopmittel sind in der US 7,149,091 B2 ringförmig um das Halbleiter-Bauelement angeordnete, planare Leiterbahnen auf dem Trägerelement vorgesehen, die geringfügig aus dem Trägerelement herausragen. Diese Lösung ermöglicht nunmehr zwar den Verzicht auf separate Fließstopmittel, wie z.B. das Aufbringen eines oder mehrerer separater Dämme um das jeweilige Halbleiter-Bauelement. Es resultieren jedoch Einschränkungen bzgl. des Layouts der Leiterbahnen auf dem Trägerelement, wenn diese zusätzlich als Fließstopmittel fungieren müssen. Ferner erfordert die Aufbringung der Leiterbahnen bzw. Fließstopmittel eine aufwendige Metallisierung über einen Maskenprozess.

Die US 2004/212082 A1 offenbart eine elektronische Bauelementanordnung, bei der auf einem Trägerelement ein Halbleiter-Bauelement angeordnet und mittels eines Kontaktierungs-Bonddrahts elektrisch kontaktiert wird. Der Kontaktierungs-Bonddraht ist in eine Vergussmasse eingebettet. Mittels eines separaten Dammes, benachbart angeordnet zum Halbleiter-Bauelement, wird das unkontrollierte Verfließen eines Klebstoff-Materials verhindert, mit dem das Halbleiter-Bauelement fixiert wird.

Aus der DE 101 53 211 A1 ist in einem elektronischen Bauteil ebenfalls als Fließstopmittel ein separates Bauteil in Form eines Dammes vorgesehen. Darüber wird das unerwünschte Verfließen eines Vergussmaterials verhindert, in das ein Kontaktierungs-Bonddraht eingebettet ist, der zur elektrischen Kontaktierung des Bauteils auf einem Trägerelement dient.

In der JP 61-102758 A wird vorgeschlagen, das unkontrollierte Verfließen von Vergussmasse im Bereich der Kontaktierungsflächen einer Halbleiter-Bauelementanordnung mit Hilfe eines Rähmchens zu verhindern.

Die JP 58-107657 A offenbart, in einer Halbleiter-Bauelementanordnung einen ringförmigen Damm aus Polyimid-Harz um ein Halbleiter-Bauelement anzuordnen. Darüber soll verhindert werden, dass das Silikon-Harz auf dem Halbleiter-Bauelement unkontrolliert verfließt.

Aufgabe der vorliegenden Erfindung ist es daher, eine Bauelementanordnung sowie ein geeignetes Verfahren zu deren Herstellung anzugeben, worüber sichergestellt ist, dass ein zum Schutz von Kontaktierungs-Bonddrähten vorgesehener Verguss möglichst ohne aufwendige Zusatzmaßnahmen am Verfließen gehindert werden kann.

Die erste angegebene Aufgabe wird gelöst durch eine Bauelementanordnung mit den Merkmalen des Anspruches 1.

Vorteilhafte Ausführungsformen der erfindungsgemäßen Bauelementanordnung ergeben sich aus den Maßnahmen, die in den von Anspruch 1 abhängigen Patentansprüchen aufgeführt sind.

Die zweite aufgeführte Aufgabe wird durch ein Verfahren zur Herstellung einer Bauelementanordnung gemäß den Maßnahmen aus Anspruch 14 gelöst.

Vorteilhafte Ausführungsformen des erfindungsgemäßen Verfahrens ergeben sich aus den Maßnahmen, die in den von Anspruch 14 abhängigen Patentansprüchen aufgeführt sind.

Erfindungsgemäß ist nunmehr vorgesehen, als Fließstoppmittel einen Fließstop-Bonddraht im Grenzbereich zwischen dem Halbleiter-Bauelement und dem Verguss anzuordnen, vorzugsweise an der Grenze zwischen der Vergussoberfläche und der bauelementseitigen Kontaktfläche des Halbleiter-Bauelements. Der Fließstop-Bonddraht kann hierbei im Rahmen des auch zur elektrischen Kontaktierung erforderlichen Bondprozesses aufgebracht werden, so dass ohne großen prozesstechnischen Zusatzaufwand ein zuverlässiger Fließstopp realisierbar ist.

Die erfindungsgemäße Bauelementanordnung umfasst ein Trägerelement, auf dem ein Halbleiter-Bauelement angeordnet ist, das über mindestens einen Kontaktierungs-Bonddraht elektrisch mit mindestens einer Kontaktfläche auf dem Trägerelement verbunden ist. In einen Verguss, bestehend aus einer Vergussmasse, ist der Kontaktierungs-Bonddraht eingebettet. Über Fließstopmittel wird zumindest in einem Teilbereich ein unkontrolliertes Verfließen der Vergussmasse verhindert. An der Grenze zwischen der Vergussoberfläche und der bauelementseitigen Kontaktfläche des Halbleiter-Bauelements ist als Fließstopmittel mindestens ein Fließstop-Bonddraht angeordnet.

Vorzugsweise bestehen der Kontaktierungs-Bonddraht und der Fließstop-Bonddraht aus dem gleichen Material.

Mit Vorteil besitzen der Fließstop-Bonddraht und der Kontaktierungs-Bonddraht den gleichen Durchmesser.

In einer möglichen Ausführungsform sind zusätzlich ein oder mehrere weitere Fließstop-Bonddrähte auch in anderen Richtungen auf dem Trägerelement angeordnet, die ein unkontrolliertes Verfließen der Vergussmasse auf dem Trägerelement auch in diesen Richtungen verhindern.

Der Fließstop-Bonddraht ist in einer vorteilhaften Ausführungsform auf der Oberseite des Halbleiter-Bauelements angeordnet.

Hierbei ist der bauelementseitige Kontakt des Kontaktierungs-Bonddrahts z.B. auf der Oberseite des Halbleiter-Bauelements zwischen dem Fließstop-Bonddraht und dem Rand des Halbleiter-Bauelements angeordnet.

Vorzugsweise wird der Fließdraht-Bonddraht an seinen zwei Enden fixiert.

Als vorteilhaft erweist sich zudem, wenn der Fließstop-Bonddraht parallel zu derjenigen Seite des Halbleiter-Bauelements angeordnet ist, die dem Verguss zugewandt ist.

In einer möglichen Variante ist das Halbleiter-Bauelement als Photoelement ausgebildet.

Mit Vorteil bedeckt der Verguss die bauelementseitige und die trägerelementseitige Kontaktfläche des Kontaktierungs-Bonddrahtes auf dem Halbleiter-Bauelement und auf dem Trägerelement.

In einer möglichen Ausführungsform ist der Fließstop-Bonddraht mit beiden Enden an der bauelementseitigen Kontaktfläche des Halbleiter-Bauelements angeordnet.

Es ist ferner möglich, dass der Fließstop-Bonddraht mindestens an einer weiteren Stelle auf der bauelementseitigen Kontaktfläche des Halbleiter-Bauelements fixiert wird.

Desweiteren kann vorgesehen werden, auf der bauelementseitigen Kontaktfläche des Halbleiter-Bauelements einen Damm als weiteres Fließstoppmittel auszubilden, der an einer Seite durch den Fließstop-Bonddraht begrenzt ist.

Im Rahmen des erfindungsgemäßen Verfahrens zur Herstellung einer Bauelementanordnung wird auf einem Trägerelement zunächst ein Halbleiter-Bauelement angeordnet. Dann wird das Halbleiter-Bauelement über mindestens einen Kontaktierungs-Bonddraht elektrisch mit mindestens einer Kontaktfläche auf dem Trägerelement verbunden. Anschließend wird ein Verguss, bestehend aus einer Vergussmasse, aufgebracht, in die der Kontaktierungs-Bonddraht eingebettet wird. Vor dem Aufbringen des Vergusses wird zumindest im Grenzbereich zwischen dem Halbleiter-Bauelement und dem Verguss bzw. an der Grenze zwischen der Vergussoberfläche und der bauelementseitigen Kontaktfläche des Halbleiter-Bauelelements als Fließstopmittel mindestens ein Fließstop-Bonddraht angeordnet.

Vorzugsweise werden der Kontaktierungs-Bonddraht und der Fließstop-Bonddraht über einen Bondprozess aufgebracht.

Es können ferner zusätzlich ein oder mehrere weitere Fließstop-Bonddrähte auch in anderen Richtungen auf dem Trägerelement angeordnet werden, die ein unkontrolliertes Verfließen der Vergussmasse auf dem Trägerelement auch in diesen Richtungen verhindern.

Vorzugsweise wird der Fließstop-Bonddraht auf der Oberseite des Halbleiter-Bauelements angeordnet.

Mit Vorteil wird der bauelementseitige Kontakt des Kontaktierungs-Bonddrahts auf der Oberseite des Halbleiter-Bauelements zwischen dem Fließstop-Bonddraht und dem Rand des Halbleiter-Bauelements angeordnet.

Vorzugsweise wird über den Verguss die bauelementseitige und die trägerelementseitige Kontaktfläche des Kontaktierungs-Bonddrahtes auf dem Halbleiter-Bauelement und auf dem Trägerelement bedeckt.

Schließlich erweist sich als vorteilhaft, wenn der der Fließdraht-Bonddraht an seinen zwei Enden fixiert wird.

Weitere Vorteile sowie Einzelheiten der vorliegenden Erfindung ergeben sich aus der nachfolgenden Beschreibung von Ausführungsbeispielen anhand der beiliegenden Figuren.

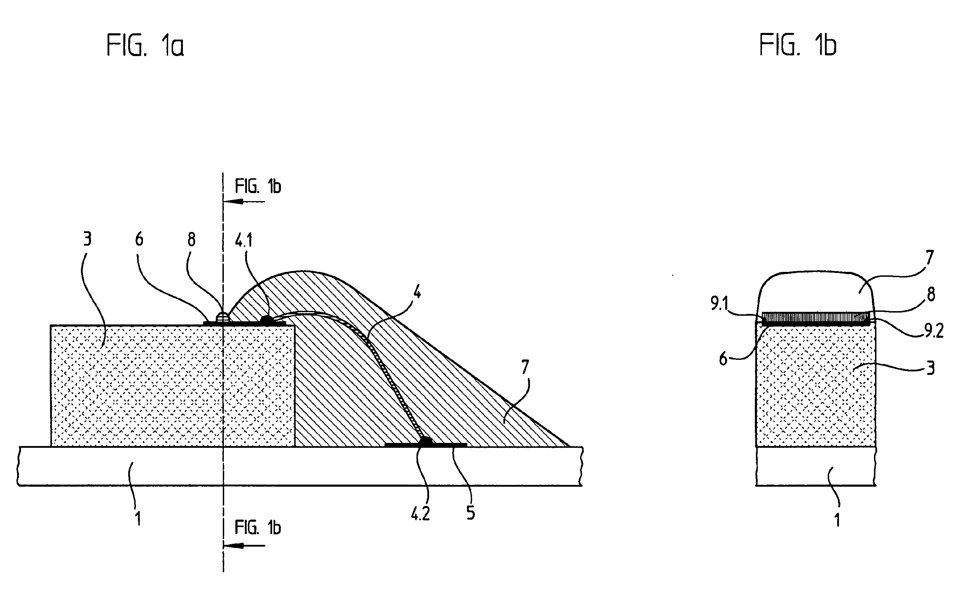

Dabei zeigt
- Figur 1a: eine schematisierte erste Schnittansicht eines ersten Ausführungsbeispieles der erfindungsge- mäßen Bauelementanordnung;
- Figur 1 b: eine schematisierte zweite Schnittansicht des Ausführungsbeispieles der erfindungsgemäßen Bauelementanordnung aus Fig. 1a;
- Figur 2: eine Draufsicht auf das Ausführungsbeispiel der erfindungsgemäßen Bauelementanordnung aus den Fig. 1a und 1b;
- Figur 3a - 3d: jeweils einen Verfahrensschritt im Rahmen des erfindungsgemäßen Verfahrens zur Herstellung einer erfindungsgemäßen Bauelementanordnung gemäß dem ersten Ausführungsbeispiel;
- Figur 4: eine schematisierte Schnittansicht eines zweiten Ausführungsbeispieles der erfindungsgemäßen Bauelementanordnung;
- Figur 5: eine Draufsicht auf ein drittes Ausführungsbei- spiel der erfindungsgemäßen Bauelement- anordnung.

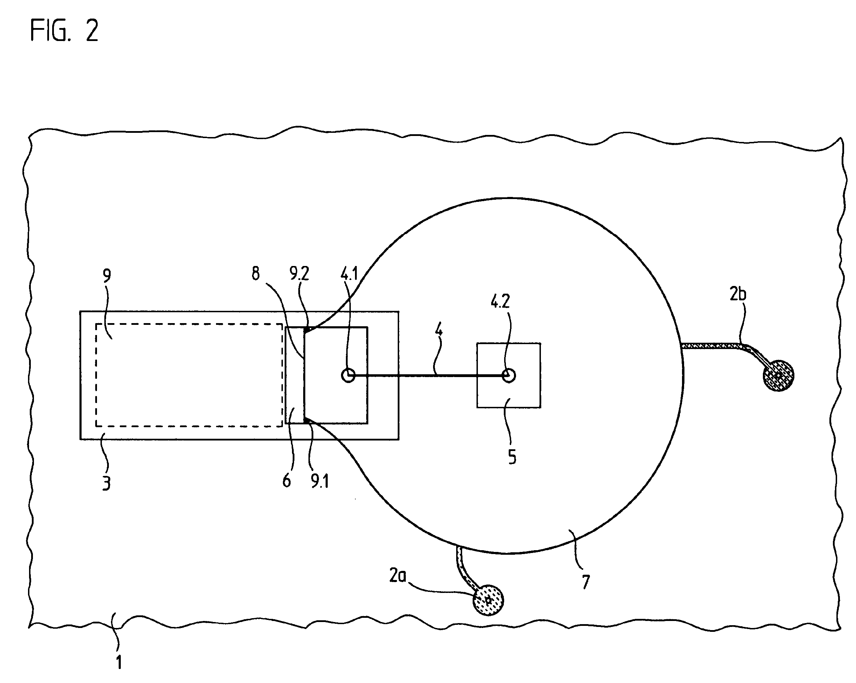

In den Figuren 1a und 1b sind Schnittansichten einer ersten Ausführungsform der erfindungsgemäßen Bauelementanordnung dargestellt; Figur 2 zeigt eine Draufsicht auf dieses Ausführungsbeispiel. Anhand dieser Figuren sei nachfolgend eine erste Variante der erfindungsgemäßen Bauelementanordnung erläutert.

Auf einem Trägerelement 1 sind die weiteren, nachfolgend zu erläuternden Komponenten der erfindungsgemäßen Bauelementanordnung angeordnet. Das Trägerelement 1 ist in diesem Beispiel als bekannte Leiterplatte aus FR4-Material ausgebildet. Alternativ kommen jedoch auch andere Materialien für das Trägerelement 1 in Betracht, wie etwa Keramik oder flexibles Leiterplattenmaterial etc..

Im bzw. auf dem Trägerelement 1 sind metallische Leiterbahnen 2a, 2b angeordnet, die zur elektrischen Kontaktierung des auf dem Trägerelement 1 angeordneten Halbleiter-Bauelementes 3 und eventueller weiterer Bauelemente dienen. Als Halbleiter-Bauelement 3 ist im dargestellten Ausführungsbeispiel ein ungehäustes Photoelement mit einer rechteckförmigen Grundfläche vorgesehen, dessen optisch funktionsrelevanter Bereich 9 in Form einer strahlungsempfindlichen Fläche vom Trägerelement 1 weg orientiert ist. Anstelle des Photoelements könnte aber auch ein anderes Halbleiter-Bauelement 3 an dieser Stelle auf dem Trägerelement 1 platziert werden; beispielsweise könnte auch eine Halbleiter-Lichtquelle vorgesehen sein, die einen optisch funktionsrelevanten Bereich in Form einer strahlungsemittierenden Fläche aufweist etc..

Die Befestigung des Halbleiter-Bauelements 3 auf dem Trägerelement 1 erfolgt im vorliegenden Ausführungsbeispiel über einen Löt-Prozess; alternativ hierzu könnte aber auch das Halbleiter-Bauelement 3 auf dem Trägerelement 1 verklebt werden.

Das Halbleiter-Bauelement 3 ist über einen Kontaktierungs-Bonddraht 4 elektrisch mit einer freiliegenden Kontaktfläche 5 auf der Oberseite des Trägerelements 1 verbunden; auf der trägerelementseitigen Kontaktfläche 5 befindet sich wie aus den Figuren ersichtlich der trägerelementseitige Kontakt 4.2 des Kontaktierungs-Bonddrahts 4. Auf der Oberseite des Halbleiter-Bauelements 3 befindet sich die bauelementseitige Kontaktfläche 6 für den bauelementseitigen Kontakt 4.1 des Kontaktierungs-Bonddrahts 4. Die Kontaktierungsflächen 5, 6 sind jeweils in bekannter Art und Weise metallisiert ausgebildet.

Zum Schutz der Bonddrahtverbindung ist ein Verguss 7, bestehend aus einer geeigneten Vergussmasse, im Bereich der Kontaktflächen 5, 6 angeordnet. Der Kontaktierungs-Bonddraht 4 ist hierbei vollständig in den Verguss 7 eingebettet und dergestalt gegen mechanische Einwirkungen und Umwelteinflüsse geschützt. Ferner bedeckt der Verguss 7 in dieser Variante vollständig die trägerelementseitige Kontaktfläche 5 des Kontaktierungs-Bonddrahts 4; die bauelementseitige Kontaktfläche 6 des Bonddrahts ist - wie nachfolgend erläutert wird - lediglich teilweise vom Verguss 7 bedeckt.

Als Material für den Verguss 7 werden vorzugsweise hochgefüllte Standard-Vergussmaterialien verwendet.

Insbesondere im Fall eines optoelektronischen Halbleiter-Bauelements 3, das wie im vorliegenden Beispiel an seiner Oberseite einen optisch funktionsrelevanten Bereich 9 in Form einer strahlungsempfindlichen Fläche aufweist, ist nunmehr zuverlässig sicherzustellen, dass der Verguss 7 nach dem Aufbringen den optisch funktionsrelevanten Bereich 9 nicht überdeckt, sondern vor dem Aushärten möglichst auf den Rest-Bereich der Oberseite des Halbleiter-Bauelements begrenzt wird, in dem der Kontaktierungs-Bonddraht 4 mit der bauelementseitigen Kontaktfläche 6 in Verbindung steht. Die Ausbreitung der Vergussmasse auf dem Trägerelement 1 in anderen Richtungen ist demgegenüber weniger kritisch und kann in bekannter Art und Weise durch geeignete Dosierung und Wahl des Vergussmaterials und/oder durch die geeignete Ausbildung des Lötstoplacks auf dem Trägerelement 1 geeignet kontrolliert werden.

Um ein unkontrolliertes Verfließen der Vergussmasse über die Oberseite des Halbleiter-Bauelements 3 zu verhindern ist als Fließstopmittel im Grenzbereich zwischen dem Halbleiter-Bauelement 3 und dem Verguss 7 bzw. an der Grenze zwischen der Vergussoberfläche und der bauelementseitigen Kontaktfläche 6 des Halbleiter-Bauelements 3 erfindungsgemäß mindestens ein Fließstop-Bonddraht 8 angeordnet. Wie aus den Figuren ersichtlich, ist der Fließstop-Bonddraht 8 im dargestellten Beispiel hierbei etwa in einem 90°-Winkel zum Kontaktierungs-Bonddraht 4 angeordnet und erstreckt sich über den Großteil der Breite des Halbleiter-Bauelements 4 in diesem Bereich. Grundsätzlich wären alternativ zum dargestellten Beispiel auch andere Anordnungs-Winkel zwischen dem Fließstop-Bonddraht 8 und dem Kontaktierungs-Bonddraht 4 möglich.

Im vorliegenden Beispiel ist der Fließstop-Bonddraht 8 auf der bauelementseitigen Kontaktfläche 6 des Kontaktierungs-Bonddrahts 4 derart angeordnet, dass sich der bauelementseitige Kontakt 4.1 des Kontaktierungs-Bonddrahtes 4 mit der Kontaktfläche 6 zwischen dem Fließstop-Bonddraht 4 und dem Rand des Halbleiter-Bauelements 3 befindet. Auf diese Art und Weise wird verhindert, dass die Vergussmasse nach dem Aufbringen in Richtung des optisch funktionsrelevanten Bereichs 9 des verwendeten Halbleiter-Bauelements 3 verfließt und diesen ggf. abdeckt. Hierzu reicht die durch den Fließstop-Bonddraht 8 ausgebildete Kante auf der Oberseite des Halbleiter-Bauelements 3 aus; an dieser Kante bzw. am Fließstop-Bonddraht 8 stoppt das weitere Verfließen der Vergussmasse und der optisch funktionsrelevante Bereich 9 des Halbleiter-Bauelements 3 bleibt unbedeckt vom Verguss. Der Fließstop-Bonddraht 8 besitzt in diesem Beispiel einen Durchmesser im Bereich von 15µm - 40µm, so dass sich damit eine Kante in einer Höhe zwischen 15µm - 40µm für die in dieser Richtung fließende Vergussmasse ausbildet.

Der Fließstop-Bonddraht 8 besitzt vorzugsweise den gleichen Durchmesser wie der Kontaktierungs-Bonddraht 4; ebenso wird für beide -Bonddrähte das gleiche Material verwendet, beispielsweise Aluminium oder ein anderes geeignetes Bonddraht-Material. Aus diesem Grund können der Kontaktierungs-Bonddraht 4 als auch der Fließstop-Bonddraht 8 im Rahmen eines identischen Bondprozesses aufgebracht werden, was die Herstellung der erfindungsgemäßen Bauelementanordnung maßgeblich vereinfacht. Insbesondere ist nunmehr zur Aufbringung der Fließstopmittel keine separater und damit aufwendiger Maskenprozess mit ein oder mehreren Metallisierungsschritten nötig. Ebenso entfallen bei diesem Ausführungsbeispiel gegenüber Lösungen mit als Damm ausgebildeten Fließstopmitteln zusätzliche Komponenten auf dem Trägerelement 1, d.h. es steht demgegenüber mehr Platz auf dem Trägerelement 1 zur Verfügung.

Der Fließstop-Bonddraht 8 wird in diesem Ausführungsbeispiel an seinen beiden Enden 9.1, 9.2 fixiert. Dies kann wie im vorliegenden Beispiel bedeuten, dass die beiden Enden 9.1, 9.2 des Fließstop-Bonddrahts 8 auf der Oberseite des Halbeiter-Bauelements 3 bzw. der bauelementseitigen Kontaktfläche 6 fixiert werden. Alternativ hierzu kann jedoch auch eine Fixierung außerhalb der Kontaktfläche 6 auf der Oberseite des Halbleiter-Bauelements erfolgen, beispielsweise auf weiteren Kontaktflächen unmittelbar auf der Oberseite des Halbleiter-Bauelements 3 oder auf Kontaktflächen des Trägerelements 1.

Wie aus Figur 1b ersichtlich, liegt im beschriebenen Ausführungsbeispiel der Fließstop-Bonddraht 8 über seine gesamte Länge auf der Kontaktfläche 6 auf. Dies ist jedoch nicht zwingend erforderlich, möglich wäre etwa auch, dass der Fließstop-Bonddraht 8 lediglich an seinen beiden fixierten Enden 9.1, 9.2 in Kontakt mit der Kontaktfläche 6 ist und im Bereich dazwischen geringfügig oberhalb der Kontaktfläche 6 verläuft. Hierbei ist natürlich zu beachten, dass der Fließstop-Bonddraht nicht zu hoch oberhalb der Kontaktfläche 6 angeordnet wird, um die Fließstop-Wirkung auf die Vergussmasse nicht zu gefährden.

Neben der erläuterten Ausführungsform einer Bauelementanordnung existieren im Rahmen der vorliegenden Erfindung selbstverständlich noch alternative Ausführungsvarianten.

So ist es etwa auch möglich, mehrere geeignet angeordnete Fließstop-Bonddrähte in Verbindung mit einem Halbleiter-Bauelement vorzusehen. Dies kann etwa nötig sein, wenn mit einem einzigen Fließstop-Bonddraht noch keine hinreichende Fließstop-Wirkung erzielbar ist oder ggf. an mehreren Seiten eines Halbleiter-Bauelements ein Verguss über einem Kontaktierungs-Bonddraht nötig ist.

Ferner könnte im Bedarfsfall auch ein dickerer Draht als Fließstop-Bonddraht eingesetzt werden als der verwendete Kontaktierungs-Bonddraht, um dergestalt ggf. einen massiveren Fließstop auszubilden; möglich wären hier Drahtdicken zwischen 15µm und 500µm.

Desweiteren könnte vorgesehen werden, nicht nur im Grenzbereich zum Halbleiter-Bauelement einen derartigen Fließstop-Bonddraht anzuordnen, sondern auch in anderen Richtungen auf dem Trägerelement im Bereich des Vergusses ein oder mehrere Fließstop-Bonddrähte anzuordnen, um darüber ein zu unkontrolliertes Verfließen der Vergussmasse in diesen Richtungen zu verhindern. Über derartige weitere Fließstop-Bonddrähte kann damit das Vergussmaterial zuverlässig in einem bestimmten Bereich auf dem Trägerelement begrenzt werden.

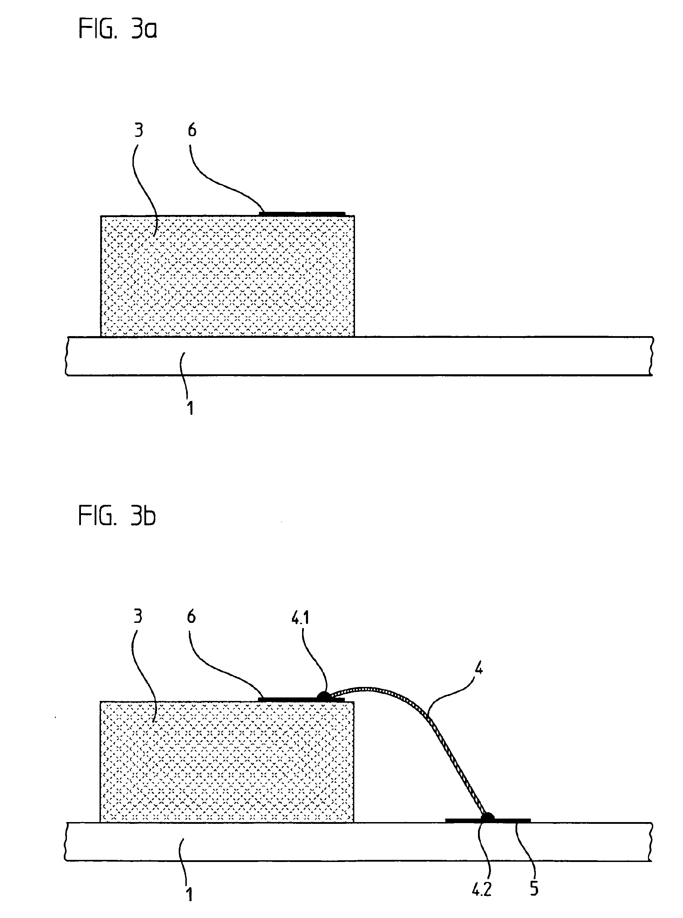

Anhand der Figuren 3a - 3d sei nachfolgend eine mögliche Ausführungsform des erfindungsgemäßen Verfahrens zur Herstellung einer Bauelementanordnung gemäß dem vorher erläuterten Ausführungsbeispiel beschrieben.

In einem ersten Prozessschritt, dargestellt in Figur 3a, wird zunächst das Halbleiter-Bauelement 3 auf dem Trägerelement 1 angeordnet. Vorzugsweise erfolgt hierbei ein Verlöten oder Verkleben des Halbleiter-Bauelements 3 auf dem Trägerelement 1.

Anschließend wird gemäß Figur 3b das Halbleiter-Bauelement 3 über einen bekannten Bondprozess elektrisch kontaktiert. Im Rahmen des hierzu vorzugsweise eingesetzten Draht-Bondprozesses wird ein Kontaktierungs-Bonddraht 4 auf übliche Art und Weise mit der trägerelementseitigen Kontaktfläche 5 und der bauelementseitigen Kontaktfläche 6 verbunden und dergestalt die Kontakte 4.1, 4.2 des Kontaktierungs-Bonddrahtes 4 mit Bauelement 3 und Trägerelement 1 ausgebildet.

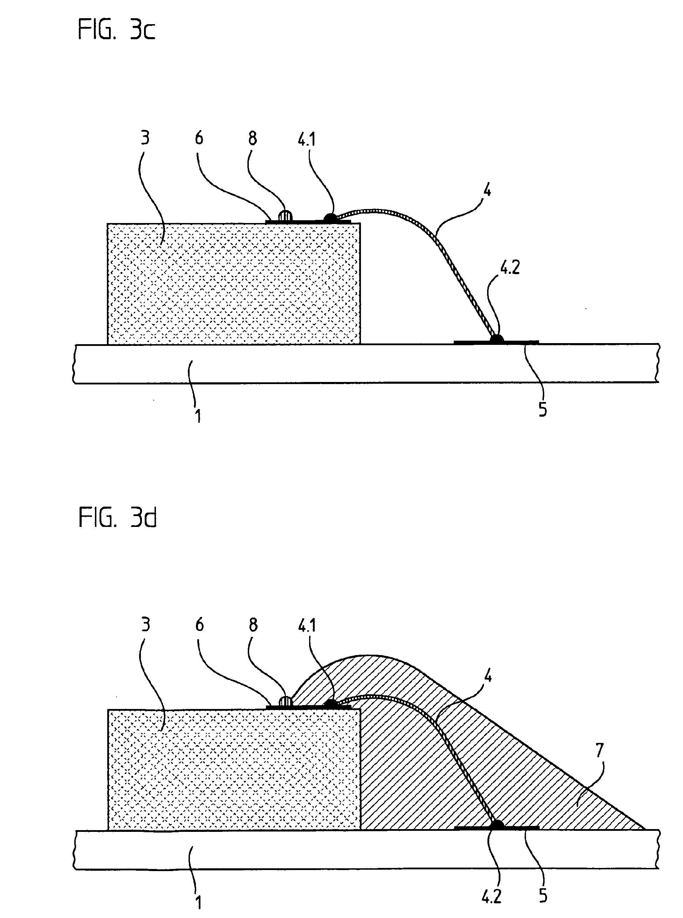

Über den gleichen Bondprozess wird daraufhin gemäß Figur 3c der als Fließstopmittel fungierende Fließstop-Bonddraht 8 auf der Oberseite des Halbleiter-Bauelements 3 bzw. auf der bauelementseitigen Kontaktfläche 6 angeordnet. Wie oben erläutert wird der Fließstop-Bonddraht 8 hierbei im wesentlichen senkrecht zum Kontaktierungs-Bonddraht 4 angeordnet und zumindest an seinen beiden Enden fixiert.

Das Aufbringen der Fließstopmittel in Form mindestens eines Fließstop-Bonddrahts 8 erfolgt erfindungsgemäß demzufolge im Rahmen des gleichen Bondprozesses wie das Aufbringen des Kontaktierungs-Bonddrahtes 4. Es resultiert eine erhebliche Prozessvereinfachung.

Selbstverständlich ist es alternativ zum erläuterten Beispiel auch möglich, zunächst den Fließstop-Bonddraht 8 aufzubringen und dann erst den Kontaktierungs-Bonddraht 4.

Abschließend wird gemäß Figur 3d schließlich der Verguss 7 bzw. die entsprechende Vergussmasse im Bereich der trägerelementseitigen Kontaktfläche 5 und der bauelementseitigen Kontaktfläche 6 des Kontaktierungs-Bonddrahtes 4 aufgebracht, so dass der Kontaktierungs-Bonddraht 4 vollständig im Verguss 7 eingebettet und mechanisch geschützt ist. Über den vorher aufgebrachten Fließstop-Bonddraht 8 wird hierbei zuverlässig verhindert, dass die Vergussmasse vor dem Aushärten unkontrolliert in den optisch funktionsrelevanten Bereich des Halbleiter-Bauelements 3 verfließt.

Auch im Rahmen des erfindungsgemäßen Verfahrens sind selbstverständlich diverse Abwandlungen des erläuterten Vorgehens denkbar.

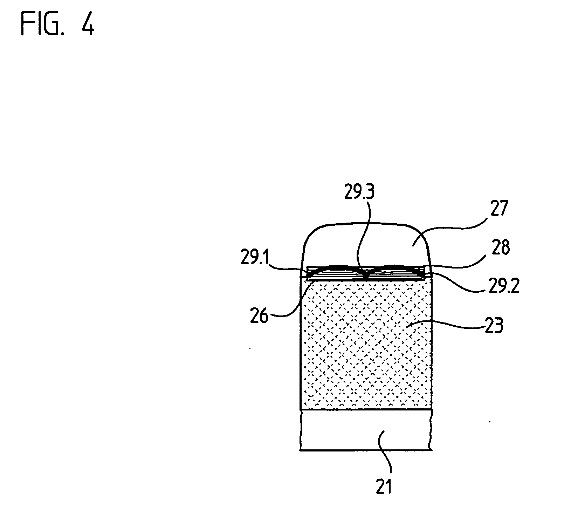

Ein zweites Ausführungsbeispiel der erfindungsgemäßen Bauelementanordnung ist in Figur 4 in einer Schnittansicht analog zur Schnittansicht aus Figur 1b gezeigt. Im Unterschied zum oben erläuterten Ausführungsbeispiel ist nunmehr vorgesehen, den Fließstop-Bonddraht 28 nicht nur an den beiden Enden 29.1, 29.2 an der bauelementseitigen Kontaktfläche 26 des Halbleiter-Bauelements 23 zu fixieren, sondern diesen zusätzlich noch an einer weiteren Stelle 29.3 auf der bauelementseitigen Kontaktfläche 26 des Halbleiter-Bauelements 23 zu fixieren. Dadurch kann noch zuverlässiger sichergestellt werden, dass kein Vergussmaterial unterhalb des Fließstop-Bonddrahts 28 in Richtung der freizuhaltenden Fläche des Halbleiter-Bauelements fließt. Denkbar wäre im Rahmen dieser Ausführungsform ferner, dass der Fließstop-Bonddraht auch noch mehr als eine Stelle außer an den Enden fixiert wird. Desweiteren könnte vorgesehen werden, einen Fließstop-Bonddraht gemäß der zweiten Ausführungsform parallel zu einem Fließstop-Bonddraht gemäß der ersten Ausführungsform anzuordnen etc..

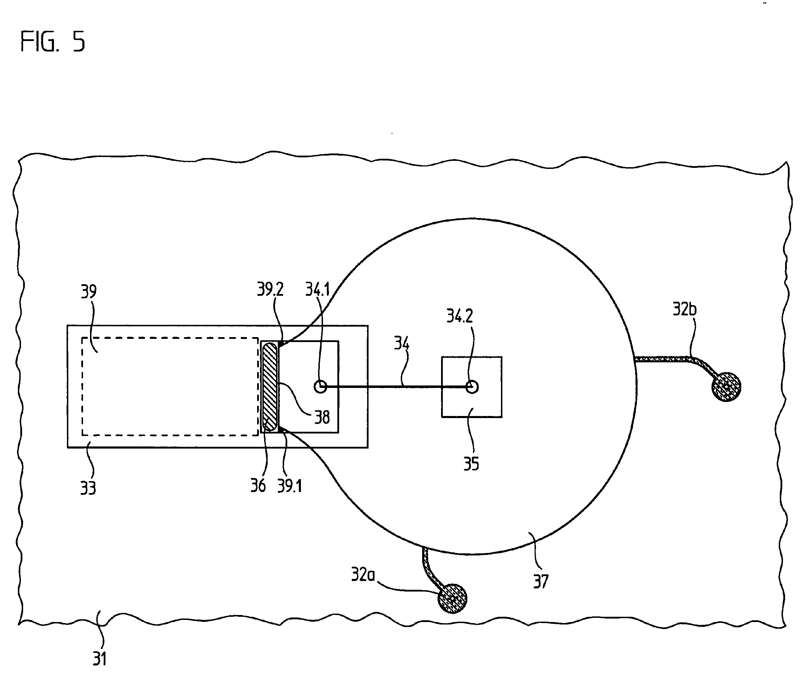

Figur 5 zeigt schließlich eine Draufsicht auf ein drittes Ausführungsbeispiel der erfindungsgemäßen Bauelementanordnung. Wie im ersten dargestellten Beispiel ist wiederum ein Fließstop-Bonddraht 38 vorgesehen, über den ein Verfließen des Vergusses 7 in Richtung des optisch funktionsrelevanten Bereichs 9 des Halbleiter-Bauelements 33 verhindert werden soll. Ergänzend zum Fließstop-Bonddraht 38 ist als weiteres Fließstoppmittel in dieser Ausführungsform ein Damm 40 auf der bauelementseitigen Kontaktfläche 36 des Halbleiter-Bauelements 33 ausgebildet. Der Damm 40 wird an einer Seite, nämlich an der dem Verguss 37 zugewandten Seite durch den Fließstopp-Bonddraht 38 begrenzt. Durch diesen Aufbau kann gegenüber der bloßen Verwendung eines Fließstop-Bonddrahts ein nochmals verbesserter Schutz des Bereichs 9 bzw. ein optimierter Fließstopp ausgebildet werden. Als Material für den Damm 40 ist ein hochviskoses Damm-Material, vorgesehen, das in bekannter Art und Weise an der entsprechenden Stelle aufgebracht wird.

Neben den konkret erläuterten Ausführungsbeispielen gibt es selbstverständlich noch weitere Ausgestaltungsmöglichkeiten im Rahmen der vorliegenden Erfindung.

## Patentansprüche

1. Bauelementanordnung, bestehend aus
- einem Trägerelement (1; 21; 31),
- einem auf dem Trägerelement (1; 21; 31) angeordneten Halbleiter-Bauelement (3; 23; 33) mit einer Kontaktfläche (6; 26; 36), mit der mindestens ein Kontaktierungs-Bonddraht (4; 34) verbunden ist, dessen anderes Ende mit mindestens einer Kontaktfläche (5; 35) auf dem Trägerelement (1; 21; 31) verbunden ist,
- einem Verguss (7; 27; 37), bestehend aus einer Vergussmasse, in die der Kontaktierungs-Bonddraht (4; 34) eingebettet ist sowie
- Fließstopmitteln, die zumindest in einem Teilbereich ein unkontrolliertes Verfließen der Vergussmasse verhindern,
**dadurch gekennzeichnet,**
**dass** als Fließstopmittel mindestens ein Fließstop-Bonddraht (8; 28; 38) an der Grenze zwischen der Vergussoberfläche und der bauelementseitigen Kontaktfläche (6; 26; 36) des Halbleiter-Bauelements (3; 23; 33) angeordnet ist.

2. Bauelementanordnung nach Anspruch 1, **dadurch gekennzeichnet, dass** der Kontaktierungs-Bonddraht (4; 34) und der Fließstop-Bonddraht (8; 28; 38) aus dem gleichen Material bestehen.

3. Bauelementanordnung nach Anspruch 1, **dadurch gekennzeichnet, dass** der Fließstop-Bonddraht (8; 28; 38) und der Kontaktierungs-Bonddraht (4; 34) den gleichen Durchmesser besitzen.

4. Bauelementanordnung nach Anspruch 1, **dadurch gekennzeichnet, dass** zusätzlich ein oder mehrere weitere Fließstop-Bonddrähte auch in anderen Richtungen auf dem Trägerelement (1; 21; 31) angeordnet sind, die ein unkontrolliertes Verfließen der Vergussmasse auf dem Trägerelement (1; 21; 31) auch in diesen Richtungen verhindern.

5. Bauelementanordnung nach Anspruch 1, **dadurch gekennzeichnet, dass** der Fließstop-Bonddraht (8; 28; 38) auf der Oberseite des Halbleiter-Bauelements (3; 23; 33) angeordnet ist.

6. Bauelementanordnung nach Anspruch 5, **dadurch gekennzeichnet, dass** der bauelementseitige Kontakt (4.1; 34.1) des Kontaktierungs-Bonddrahts (4; 34) auf der Oberseite des Halbleiter-Bauelements (3; 23; 33) zwischen dem Fließstop-Bonddraht (8; 28; 38) und dem Rand des Halbleiter-Bauelements (3; 23; 33) angeordnet ist.

7. Bauelementanordnung nach Anspruch 1, **dadurch gekennzeichnet, dass** der Fließstop-Bonddraht (8; 28; 38) an seinen zwei Enden (9.1, 9.2; 29.1, 29.2; 39.1, 39.2) fixiert ist.

8. Bauelementanordnung nach Anspruch 1, **dadurch gekennzeichnet, dass** der Fließstop-Bonddraht (8; 28; 38) parallel zu derjenigen Seite des Halbleiter-Bauelements (3; 23; 33) angeordnet ist, die dem Verguss (7; 27; 37) zugewandt ist.

9. Bauelementanordnung nach Anspruch 1, **dadurch gekennzeichnet, dass** das Halbleiter-Bauelement (3; 23; 33) als Photoelement ausgebildet ist.

10. Bauelementanordnung nach Anspruch 1, **dadurch gekennzeichnet, dass** der Verguss (7; 27; 37) den bauelementseitigen und den trägerelementseitigen Kontakt (4.1, 4.2; 34.1) des Kontaktierungs-Bonddrahtes (4; 34) auf dem Halbleiter-Bauelement (3; 23; 33) und auf dem Trägerelement (1; 21; 31) bedeckt.

11. Bauelementanordnung nach Anspruch 1, **dadurch gekennzeichnet, dass** der Fließstop-Bonddraht (8; 28; 38) mit beiden Enden (9.1, 9.2; 29.1, 29.2; 39.1, 39.2) an der bauelementseitigen Kontaktfläche (6; 26; 36) des Halbleiter-Bauelements (3; 23; 33) angeordnet ist.

12. Bauelementanordnung nach Anspruch 7, **dadurch gekennzeichnet, dass** der Fließstop-Bonddraht (28) mindestens an einer weiteren Stelle (29.3) auf der bauelementseitigen Kontaktfläche (26) des Halbleiter-Bauelements (23) fixiert ist.

13. Bauelementanordnung nach mindestens einem der vorhergehenden Ansprüche, **dadurch gekennzeichnet, dass** auf der bauelementseitigen Kontaktfläche (36) des Halbleiter-Bauelements (33) ein Damm (40) als weiteres Fließstoppmittel ausgebildet ist, der an einer Seite durch den Fließstop-Bonddraht (38) begrenzt ist.

14. Verfahren zur Herstellung einer Bauelementanordnung, wobei
- auf einem Trägerelement (1; 21; 31) ein Halbleiter-Bauelement (3; 23; 33) angeordnet wird,
- das Halbleiter-Bauelement (1; 21; 31) über mindestens einen Kontaktierungs-Bonddraht (4; 24; 34) elektrisch mit mindestens einer Kontaktfläche (6; 26; 36) auf dem Trägerelement (1; 21; 31) verbunden wird und
- ein Verguss (7; 27; 37), bestehend aus einer Vergussmasse, aufgebracht wird, in die der Kontaktierungs-Bonddraht (4; 24; 34) eingebettet ist,
**dadurch gekennzeichnet,**
**dass** vor dem Aufbringen des Vergusses (7; 27; 37) an der Grenze zwischen der Vergussoberfläche und der bauelementseitigen Kontaktfläche (6; 26; 36) des Halbleiter-Bauelements (3; 23; 33) als Fließstopmittel mindestens ein Fließstop-Bonddraht (8; 28; 38) angeordnet wird.

15. Verfahren nach Anspruch 14, **dadurch gekennzeichnet, dass** der Kontaktierungs-Bonddraht (4; 34) und der Fließstop-Bonddraht (8; 28; 38) über einen Bondprozess aufgebracht werden.

## Claims

1. A component arrangement, consisting of
- a carrier element (1; 21; 31),
- a semiconductor component (3; 23; 33) which is arranged on the carrier element (3; 23; 33) and has a contact surface (6; 26; 36) to which at least one contact-making bonding wire (4; 34) is connected, the other end of which is connected to at least one contact surface (5; 35) on the carrier element (1; 21; 31),
- a potting (7; 27; 37) consisting of a potting compound into which the contact-making bonding wire (4; 34) is embedded, and
- flow stop means which, at least in a partial region, prevent an uncontrolled flowing of the potting compound,
**characterized in**
**that** as flow stop means at least one flow stop bonding wire (8; 28; 38) is arranged at the boundary between the potting surface and the component-side contact surface (6; 26; 36) of the semiconductor component (3; 23; 33).

2. The component arrangement according to claim 1, **characterized in that** the contact-making bonding wire (4; 34) and the flow stop bonding wire (8; 28; 38) consist of the same material.

3. The component arrangement according to claim 1, **characterized in that** the flow stop bonding wire (8; 28; 38) and the contact-making bonding wire (4; 34) have the same diameter.

4. The component arrangement according to claim 1, **characterized in that** in addition, one or more flow stop bonding wires are arranged also in other directions on the carrier element (1; 21; 31) which prevent an uncontrolled flowing of the potting compound on the carrier element (1; 21; 31) also in these directions.

5. The component arrangement according to claim 1, **characterized in that** the flow stop bonding wire (8; 28; 38) is arranged on the upper side of the semiconductor component (3; 23; 33).

6. The component arrangement according to claim 5, **characterized in that** the component-side contact (4.1; 34.1) of the contact-making bonding wire (4; 34) is arranged on the upper side of the semiconductor component (3; 23; 33) between the flow stop bonding wire (8; 28; 38) and the edge of the semiconductor component (3; 23; 33).

7. The component arrangement according to claim 1, **characterized in that** the flow stop bonding wire (8; 28; 38) is fixed at its two ends (9.1, 9.2, 29.1, 29.2; 39.1, 39.2).

8. The component arrangement according to claim 1, **characterized in that** the flow stop bonding wire (8; 28; 38) is arranged parallel to that side of semiconductor component (3; 23; 33) which faces toward the potting (7; 27; 37).

9. The component arrangement according to claim 1, **characterized in that** the semiconductor component (3; 23; 33) is configured as photoelement.

10. The component arrangement according to claim 1, **characterized in that** the potting (7; 27; 37) covers the component-side and the carrier element-side contact (4.1, 4.2; 34.1) of the contact-making bonding wire (4; 34) on the semiconductor component (3; 23; 33) and on the carrier element (1; 21; 31).

11. The component arrangement according to claim 1, **characterized in that** the flow stop bonding wire (8; 28; 38) is arranged with both ends (9.1, 9.2; 29.1, 29.2; 39.1, 39.2) on the component-side contact surface (6; 26; 36) of the semiconductor component (3; 23; 33).

12. The component arrangement according to claim 7, **characterized in that** the flow stop bonding wire (28) is fixed on at least one further place (29.3) on the component-side contact surface (26) of the semiconductor component (23).

13. The component arrangement according to at least one of the preceding claims, **characterized in that** on the component-side contact surface (36) of the semiconductor component (33), a barrier (40) is formed as further flow stop means which is bounded on one side by the flow stop bonding wire (38).

14. A method for producing a component arrangement,
wherein
- a semiconductor component (3; 23; 33) is arranged on a carrier element (1; 21; 31),
- the semiconductor component (1; 21; 31) is electrically connected via at least one contact-making bonding wire (4; 24; 34) to at least one contacting surface (6; 26; 36) on the carrier element (1; 21; 31) and
- a potting (7; 27; 37) consisting of a potting compound is applied into which the contact-making bonding wire (4; 24; 34) is embedded, **characterized in**
**that** prior to applying the potting (7; 27; 37), at least one flow stop bonding wire (8; 28; 38) is arranged as flow stop means at the boundary between the potting surface and the component-side contact surface (6; 26; 36) of the semiconductor component (3; 23; 33).

15. The method according to claim 14, **characterized in that** the contact-making bonding wire (4; 34) and the flow stop bonding wire (8; 28; 38) are applied through a bonding process.

## Revendications

1. Agencement de composant de construction, comprenant :
- un élément support (1 ; 21 ; 31),
- un composant à semi-conducteurs (3 ; 23 ; 33) disposé sur l'élément support (1 ; 21 ; 31) avec une surface de contact (6 ; 26 ; 36), à laquelle au moins un fil de bonding de mise en contact (4 ; 34) est relié, dont l'autre extrémité est reliée à au moins une surface de contact (5 ; 35) sur l'élément support (1 ; 21 ; 31),
- un scellement (7 ; 27 ; 37), comprenant une masse de scellement dans laquelle le fil de bonding de mise en contact (4 ; 34) est encastré et
- des moyens d'arrêt d'écoulement qui empêchent au moins dans une zone partielle un écoulement incontrôlé de la masse de scellement,
**caractérisé**
**en ce qu'**au moins un fil de bonding d'arrêt d'écoulement (8 ; 28 ; 38) est disposé comme moyen d'arrêt d'écoulement à la limite entre la surface de scellement et la surface de contact (6 ; 26 ; 36) côté composant du composant à semi-conducteurs (3 ; 23 ; 33).

2. Agencement de composant selon la revendication 1, **caractérisé en ce que** le fil de bonding de mise en contact (4 ; 34) et le fil de bonding d'arrêt d'écoulement (8 ; 28 ; 38) sont dans le même matériau.

3. Agencement de composant selon la revendication 1, **caractérisé en ce que** le fil de bonding d'arrêt d'écoulement (8 ; 28 ; 38) et le fil de bonding de mise en contact (4 ; 34) présentent le même diamètre.

4. Agencement de composant selon la revendication 1, **caractérisé en ce qu'**en supplément un ou plusieurs autres fils de bonding d'arrêt d'écoulement sont disposés également dans d'autres directions sur l'élément support (1 ; 21 ; 31), qui empêchent un écoulement incontrôlé de la masse de scellement sur l'élément support (1 ; 21 ; 31) également dans ces directions.

5. Agencement de composant selon la revendication 1, **caractérisé en ce que** le fil de bonding d'arrêt d'écoulement (8 ; 28 ; 38) est disposé sur le côté supérieur du composant à semi-conducteurs (3 ; 23 ; 33).

6. Agencement de composant selon la revendication 5, **caractérisé en ce que** le contact (4.1 ; 34.1) côté composant du fil de bonding de mise en contact (4 ; 34) est disposé sur le côté supérieur du composant à semi-conducteurs (3 ; 23 ; 33) entre le fil de bonding d'arrêt d'écoulement (8 ; 28 ; 38) et le bord du composant à semi-conducteurs (3 ; 23 ; 33).

7. Agencement de composant selon la revendication 1, **caractérisé en ce que** le fil de bonding d'arrêt d'écoulement (8 ; 28 ; 38) est fixé sur ses deux extrémités (9.1, 9.2 ; 29.1, 29.2 ; 39.1, 39.2).

8. Agencement de composant selon la revendication 1, **caractérisé en ce que** le fil de bonding d'arrêt d'écoulement (8 ; 28 ; 38) est disposé parallèlement au côté du composant à semi-conducteurs (3 ; 23 ; 33) qui est tourné vers le scellement (7 ; 27 ; 37).

9. Agencement de composant selon la revendication 1, **caractérisé en ce que** le composant à semi-conducteurs (3 ; 23 ; 33) est conçu comme photocopile.

10. Agencement de composant selon la revendication 1, **caractérisé en ce que** le scellement (7 ; 27 ; 37) recouvre le contact (4.1, 4.2 ; 34.1) côté composant et le contact côté élément support du fil de bonding de mise en contact (4 ; 34) sur le composant à semi-conducteurs (3 ; 23 ; 33) et l'élément support (1 ; 21 ; 31).

11. Agencement de composant selon la revendication 1, **caractérisé en ce que** le fil de bonding d'arrêt d'écoulement (8 ; 28 ; 38) est disposé avec les deux extrémités (9.1, 9.2 ; 29.1, 29.2 ; 39.1, 39.2) sur la surface de contact (6 ; 26 ; 36) côté composant du composant à semi-conducteurs (3 ; 23 ; 33).

12. Agencement de composant selon la revendication 7, **caractérisé en ce que** le fil de bonding d'arrêt d'écoulement (28) est fixé au moins en un autre endroit (29.3) sur la surface de contact (26) côté composant du composant à semi-conducteurs (23).

13. Agencement de composant selon au moins l'une quelconque des revendications précédentes, **caractérisé en ce qu'**un remblai (40), qui est délimité sur un côté par le fil de bonding d'arrêt d'écoulement (38), est conçu comme autre moyen d'arrêt d'écoulement sur la surface de contact (36) côté composant du composant à semi-conducteurs (33).

14. Procédé pour fabriquer un agencement de composant,
- un composant à semi-conducteurs (3 ; 23 ; 33) étant disposé sur un élément support (1 ; 21 ; 31),
- le composant à semi-conducteurs (1 ; 21 ; 31) étant relié par au moins un fil de bonding de mise en contact (4 ; 24 ; 34) électriquement à au moins une surface de contact (6 ; 26 ; 36) sur l'élément support (1 ; 21 ; 31) et
- un scellement (7 ; 27 ; 37) constitué d'une masse de scellement étant appliqué, dans laquelle le fil de bonding de mise en contact (4 ; 24 ; 34) est encastré,
**caractérisé**
**en ce qu'**au moins un fil de bonding d'arrêt d'écoulement (8 ; 28 ; 38) est disposé avant l'application du scellement (7 ; 27 ; 37) sur la limite entre la surface de scellement et la surface de contact (6 ; 26 ; 36) côté composant du composant à semi-conducteurs (3 ; 23 ; 33), comme moyen d'arrêt d'écoulement.

15. Procédé selon la revendication 14, **caractérisé en ce que** le fil de bonding de mise en contact (4 ; 34) et le fil de bonding d'arrêt d'écoulement (8 ; 28 ; 38) sont appliqués au moyen d'un processus de bonding.
